# EUROPEAN PATENT APPLICATION

(11) **EP 4 636 740 A1**
(43) Date of publication of application: **22.10.2025**
(21) Application number: 24171034.2
(22) Date of filing: 18.04.2024
(51) Int. Cl.: G09F 9/33, G09F 19/02, G09F 19/12

(54) **A DISPLAY DEVICE**

(71) Applicant: Harman Professional Denmark ApS, 8200 Aarhus N (DK)
(72) Inventor: NIELSEN, Christian Quist, 9500 Hobro (DK)
(74) Representative: Kraus & Lederer PartGmbB

(57) **Abstract**

The present disclosure provides a display device (1) comprising a shell (2) and a plurality of light sources (10). The device (1) is configured for displaying a three-dimensional picture by coordinated activation of a plurality of the light sources (10). At least some of the light sources (10) are arranged to form at least one ring (12). A plurality of the light sources (10) is arranged along a straight line on at least one flexible PCB, where the at least one PCB extends at least along a part of the ring (12).

## Description

### Field of the disclosure

The present disclosure relates to a display device comprising a shell and a plurality of light sources, where the display device is configured for displaying a three-dimensional picture.

### Background of the disclosure

Display devices are typically used to display information in the form of pictures, such as moving images including videos.

### Description of the disclosure

It is an object of embodiments of the disclosure to provide an improved display device.

Accordingly, the disclosure provides a display device comprising a shell forming an inner space and having an outer surface and an opposite inner surface, and a plurality of light sources, the device being configured for displaying a three-dimensional picture by coordinated activation of a plurality of the light sources, and wherein at least some of the light sources are arranged to form at least one ring.

The shell forms an inner space, where an inner surface faces the inner space, and where an opposite outer surface faces the surroundings. The shell may comprise a plurality of shell parts, where each shell part may be releasably attached to an adjacent shell part to allow assembling of the shell and allow detachment of at least one shell part from the remaining shell part. By detachment of one or more shell parts, assess to the inner space may be provided. The shell may alternatively or additionally be provided with one or more openings which may allow access to the inner space.

The shell may be of any arbitrary three-dimension shape, such as a sphere, an ellipsoid, a hemisphere, a cone, a cylinder, a cube, a dodecahedron, an icosahedron, etc. In a preferred embodiment, the shape of the shell may be substantially the shape of a sphere. The sphere may have a diameter in the range of 0.1-2.5 m.

The device comprises a plurality of light sources and is configure for displaying a three-dimensional picture, such as moving images, such as a video, by coordinated activation of a plurality of the light sources. In the context of the present disclosure, the term 'picture' should be understood as any kind of content which may be displayed by use of a plurality of light sources; i.e., images, moving images, video, graphical effects, animations, etc. As an example, the light sources may be one or more RGB LEDs and/or one or more RGBW LEDs and/or LEDs including e.g., amber and/or lime and/or one or more laser light sources and/or a combination of one or more of these light sources. Some of the light sources are used to create the pictures/moving images/video, whereas some of the light sources may be used e.g., to provide a brighter output in the form of beams.

In the context of the present disclosure, the term 'three-dimensional picture' should be understood as a picture being formed by coordinated activation of light source being arranged in three dimensions. This is achieved by arranging at least some of the light sources to form at least one ring.

The display device may comprise a control unit for coordinated activation of a plurality of the light sources. The control unit may be arranged at a distance to the shell and may send a control signal to the light sources for activation hereof. The control signal may be transmitted wireless or by wire to the light sources. In an alternative embodiment, the control unit may be arranged in the inner space. In the latter embodiment, a main controller may, however, be arranged outside the inner space for communication with a control unit in the inner space, e.g., for coordinated control of a plurality of display devices.

At least some of the light sources are arranged to form at least one ring. In the context of the present disclosure, the term 'ring' should be understood as an element forming a closed element with an opening inside the ring transverse to the ring. The ring may be of any shape, such as in the form of a square, a triangle, an ellipse, etc. In a one embodiment the at least one ring may be circular. The ring may be a non-physical element defined by the position of the light sources which may be arranged at a distance to each other.

By arranging at least some of the light sources so that they form a ring, display of a three-dimensional picture/video by coordinated activation of a plurality of the light sources may be facilitated, as one light source of the ring may emit light in different direction than another light source of the same ring.

At least some of the light sources may be arranged to form a sphere. This may as an example be achieved by providing a plurality of the light sources to form a plurality of rings which together forms a sphere. A total of e.g., two, three, four, or more, such as 8, 9, 10, 11, 12 rings or even more may be provided.

In one embodiment, a plurality of the light sources is arranged along a straight line on at least one flexible PCB. The at least one PCB may extend at least along a part of the ring. In one embodiment, each ring may be formed by light sources arranged along a straight line on two flexible PCBs following each other to form a ring. The distance between two adjacent light sources may be in the range of 5.0-50.0 mm, such as 10.0-40.0 mm.

To limit the size of the elements required to control the light sources, at least some of the light sources may comprise a built-in driver, e.g., light sources in the form of LEDs with built-in LED drivers. Additionally, a serial interface may be used.

The at least one flexible PCB may be arranged in the inner space along the inner surface of the shell. The shell may comprise a plurality of openings, where the light sources arranged on the PCB may extend at least partly through the openings to allow light beams from the light sources to form a three-dimensional picture, e.g., moving images, such as a video, outside the inner space, such as along an outer surface of the shell. The shell may comprise more openings than the total number of light sources arranged on the PCB(s), as some openings may be used for other purposes, such as for light sources not arranged on the PCB(s).

A plurality of PCBs may extend from an upper section of the shell to a lower section of the shell, where the upper section and the lower section cover opposite extremities of the shell, when ready for use or in use. A first distance between two neighbouring PCBs at the upper section and at the lower section may be smaller than a second distance between two neighbouring PCBs at a shell centre line between the upper and the lover section. In an alternative embodiment, the PCB(s) together substantially cover the shell. In this embodiment, a first distance between two neighbouring lines of light sources at the upper section and at the lower section may be smaller than a second distance between two neighbouring lines of light sources at the shell centre.

The shell may have the form of a sphere, where the PBC(s) may extend from an upper section of the shell to a lower section of the shell. The PCB(s) may terminate at the upper and the lower extremes of the sphere, or may terminate at a distance from the upper and lower extremes; i.e., at the upper and lower sections. As an example, the PCB(s) may terminate at a distance in the range of 10-100 mm. The distance at the upper section may be different than the distance at the lower section.

When arranging the PCB(s) along the inner surface of a shell in the form of a sphere, the width of the PCB(s) may decrease towards the end points, i.e., towards the upper section and the lower section, where the width is defined as the dimension of a PCB transverse to the length of the PCB, the length being define as the distance of the PCB between opposite free ends terminating at the upper section and the lower section, respectively.

The shell may define a centre axis extending through a geometrical centre of the shell from a top part of the upper section (the upper extreme in use/ready for use state) and a bottom part of the lower section (the lower extreme in use/ready for use state). Each PCBs may be arranged such that each light source of that PCB is arranged in a plane extending through the shell centre axis. Thus, the PCBs may extend along the shortest path from the upper section to the lower section. Furthermore, it may be achieved that one PCB does not extend transverse to another PCB.

The light sources may be arranged equidistant along all the PCB(s) or alternatively along at least some of the PCB(s). In an embodiment, where the shell has the form of a sphere, equidistant arranged light sources may result in light sources being arranged close to each other at the upper section and at the lower section due to the smaller diameter of the sphere and consequently the smaller width of the PCB(s). In response to a decreased area for each light source at the upper and the lower sections, the light sources arranged in these sections may be smaller than the light sources arranged outside the upper and the lower sections. As an example, the light sources arranged along a straight line on the flexible PCB(s) in the area between the upper and the lower sections may be LEDs, whereas the light sources arranged along the same straight line on the flexible PCB(s) in the upper and the lower section may be light guiding rods of different lengths. One or more light sources for the light guiding rods may be arranged in the inner space.

A plurality of the PCBs may be arranged symmetrically relative to each other along shell, such as along the inner surface of the shell. In one embodiment, each of the PCB(s) are arranged symmetrically relative to each other and relative to the shell. The output of the display device may as an example be varied by varying the type and/or number of light sources and/or the pixel pitch.

The display device may further comprise a supplementary source of light extending along the outer surface of the shell transverse to the shell centre axis. By providing a supplementary source of light transverse to shell centre axis, the supplementary source of light may extend transverse to at least a plurality of the PCB(s) on which a plurality of light sources may be arranged. In one embodiment, the supplementary source of light extends circumferentially around the shell along a centre line of the shell. In an embodiment, where the shell has the shape of a sphere, the supplementary source of light may extend transverse to the centre axis along the shell centre line extending perpendicular hereto. In addition to or alternative to a supplementary source of light extending along the shell centre axis, a supplementary centre axis may extend along the outer surface of the shell forming a helix or forming another shape. A second supplementary source of light may extend transverse to the shell centre axis at another position. By arranging the supplementary source of light transverse to the PCB(s) with the light sources on a straight line, an enhanced visual experience may be provided.

The supplementary source of light may be a strobe element, such as a strobe ring with high intensity light. In one embodiment, this may be achieved by a high-power LED with a light rod. In an alternative embodiment, the supplementary source of light may comprise a plurality of LEDs arranged on a line on a flexible PCB. To provide a strobe effect, the plurality of LEDs may be individually driven white LEDs.

As an alternative to or in addition to a plurality of light sources arranged along a straight line on at least one flexible PCB inside the shell, the display device may comprise a carrier element carrying a plurality of light sources, where the carrier element may be arranged along the outer surface of the shell. The carrier element may be movably arranged relative to the shell to allow rotation of the carrier element around the shell. A three-dimensional picture, e.g., moving images, such as video, may be displayed by coordinated activation of a plurality of the light sources during rotation of the carrier element. The carrier element may rotate/spin with a speed in the range of 800-1200 rpm; such as a speed of approximately 1000 rpm. The speed may as an example depend on the required refresh rate of the picture/moving images/video.

The carrier element may comprise two carrier arms, such as half-rings, each extending along the outer surface of the shell. To facilitate stability of the display device, the two arms may be symmetrically arranged relative to the shell. In an alternative embodiment, the carrier element may comprise three, four, five, or even more carrier arms. The carrier arms may be evenly distributed along the outer surface of the shell.

The light sources at the carrier arms may be arranged along a straight line extending from an upper section of the shell to a lower section of the shell to cover most of the shell during rotation of the carrier element. The light sources of a first carrier arm may be staggered relative to the light sources of a second carrier arm, the light sources being staggered in a direction from the upper section to the lower section. The distance between two adjacent light sources may be in the range of 0.5-3.0 mm, such as 0.7-2.0 mm. By the use of larger LEDs, the distance between two adjacent light sources may, however, be larger. The light sources may be LEDs, such as RGB LEDs, arranged on a PCB including high-speed LED drivers.

The display device may further comprise a motor configured to rotate the carrier element relative to the shell. As an example, the motor may be a brushless motor. Power and data for the rotatable carrier element may be provided via a slip ring. As an alternative the power may be transferred by a wireless power transfer. Additionally, data may be transferred via an optical link to remove the need for a slipring.

When the carrier elements are rotated with the light sources, such as the LEDs, a picture, such as a video, may be displayed on the outer surface of the shell. To enable synchronisation of the light sources to provide the required picture/video, high precision encoders may be applied on the brushless motor.

The display device may comprise a cover arranged circumferential around the shell, e.g., for protection of the light sources. In an embodiment comprising a movable carrier element with light sources, the cover may be arranged circumferential around both the shell and the carrier element, as this may prevent a person touching the moving (spinning) carrier element.

At least some of the light sources may be covered by a diffuser or a lens, where the diffuser may spread the light beams to make the output softer, and where the lens may converge light beams. The display device may comprise a cover arranged circumferentially around the shell, where the cover may comprise the diffusers and/or the lenses. As an example, the cover may be made of a material which scatters light. By replacing some areas of the cover with another material, the cover may have different diffuser properties at different areas. As a further alternative, areas of the cover may be replaced by lenses to have a cover having diffuser properties in combination with lenses.

The display device may comprise a replaceable cover. As an example, the cover may comprise a plurality of cover parts which may be releasable attached to each other. The different cover part may be releasable attached to each other e.g., by snap-fit coupling, by a magnetic coupling, or by other couplings.

The display device may additionally or alternatively comprise a plurality of reflective elements for reflection of light emitted from at least some of the light sources. The reflective elements may be mirrors or may be of a material with a different reflection coefficient. The reflective element(s) may be integrated in the cover.

The display device may comprise a wire configured to carry the shell, e.g., to hang the shell from the ceiling or from a carrier structure. The wire may extend from the inner space to the surrounding space via an opening in the shell, where the opening may be arranged at the top part of the shell. A first end of the wire may be attached to a fixation element in the inner space. An opposite second end may be attached to a second fixation element e.g., at the ceiling or at the carrier structure. Stability of the display device may be facilitated, as the wire may extend along the centre axis of the shell through the top part to the second fixation element. As an alternative to hanging the shell, the display device may comprise a floor stand on which the shell may be fixed.

In one embodiment, the display device comprises a winch positioned in the inner space. The fixation element may be fixed to the winch, where the winch may be configured for up and down movement of the shell. The up and down movement may be along the centre axis of the shell. In an alternative embodiment, a winch may be position outside the shell. In this embodiment, the second fixation element may be fixed to the winch. The winch may be motorised.

A control unit may be arranged to enable control of the up and down movement. A control signal may be transmitted wireless or by wire to the motorised winch. The control unit may form part of a main controller which may additionally control the coordinated activation of the light sources. Furthermore, it may be possible to control up and down movement of a plurality of shell to e.g., coordinate up and down movement a plurality of shells simultaneously.

The display device may comprise a fan positioned in the inner space of the shell. The fan may be configured to cool the inner space, which may be heated by the plurality of light sources. In one embodiment, the fan is configured to provide a flow of air from outside the shell to the inner space and from the inner space to the outside. As an example, the flow may be provided via an opening in the bottom part of the shell and a corresponding opening at the top part of the shell.

### Brief description of the drawings

Embodiments of the disclosure will now be further described with reference to the drawings, in which:
- Fig. 1: illustrates an embodiment of a display device;
- Fig. 2: illustrates a cross-section through the display device of Fig. 1;
- Fig. 3: illustrates a detail of the display device of Figs. 1 and 2; and
- Fig. 4: illustrates an alternative embodiment of display device.

### Detailed description of the drawings

It should be understood that the detailed description and specific examples, while indicating embodiments of the disclosure, are given by way of illustration only, since various changes and modifications within the spirit and scope of the disclosure will become apparent to those skilled in the art from this detailed description.

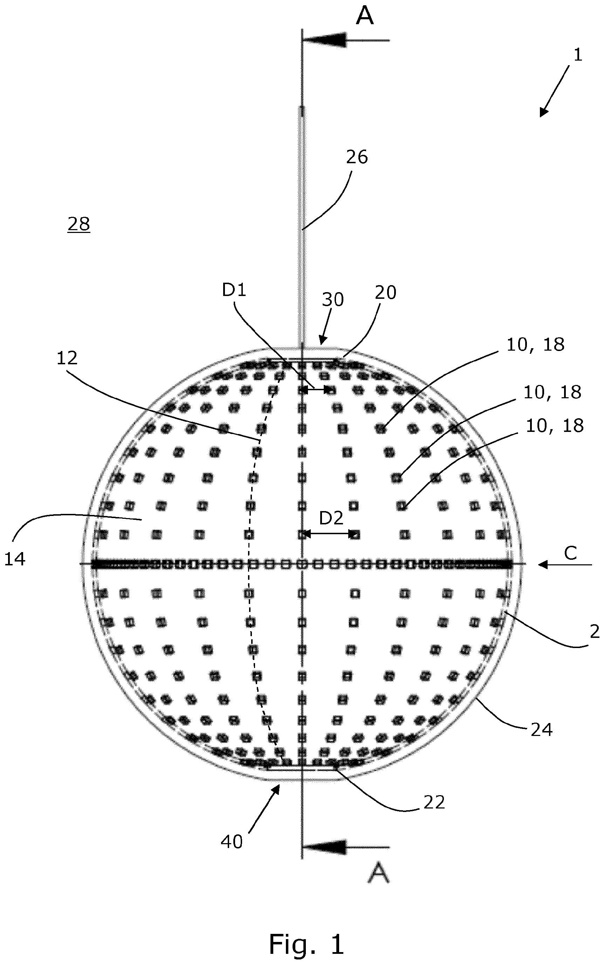

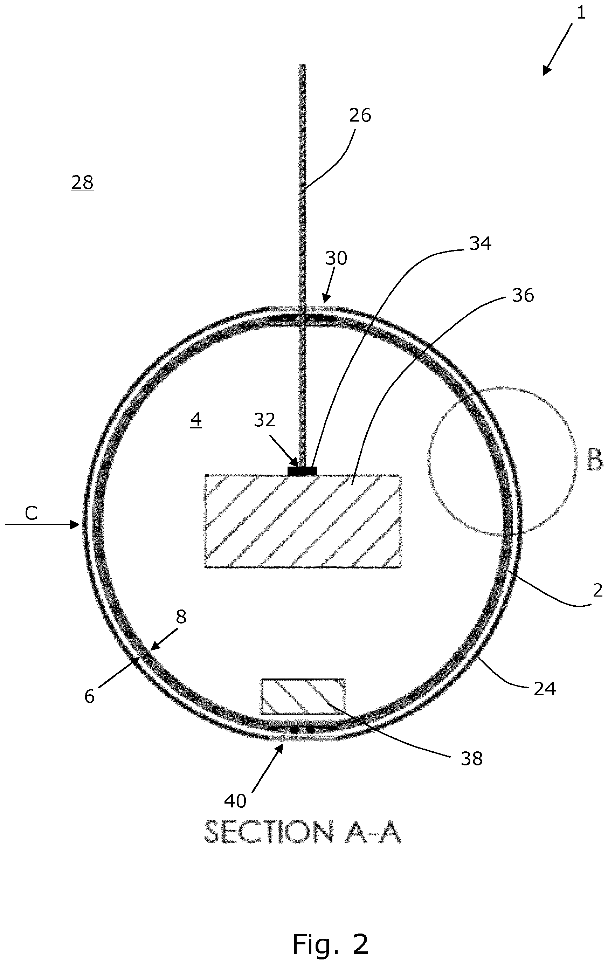

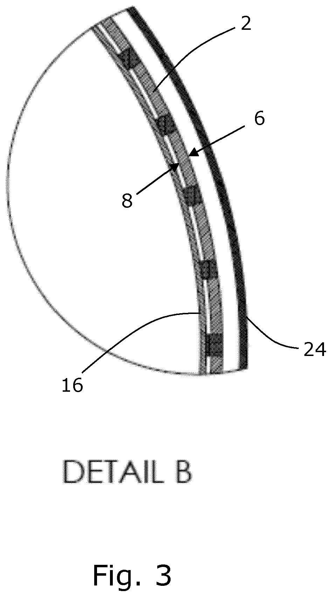

Figs. 1, 2 and 3 illustrate different views of an embodiment of a display device 1, where Fig. 2 illustrates a cross-section through the display device of Fig. 1; and where Fig. 3 illustrates a detail of the display device of Figs. 1 and 2.

The display device 1 comprises a shell 2 forming an inner space 4. The shell 2 has an outer surface 6 and an opposite inner surface 8. The display device 1 comprises a plurality of light sources 10, and is configured for displaying a three-dimensional picture, such as moving images, such as video, by coordinated activation of a plurality of the light sources 10. In the illustrated embodiment, most of the light sources 10 are arranged to form a plurality of rings 12 (indicated by the line) along the outer surface 6 of the shell 2.

In the illustrated embodiment, the rings 12 are substantially circular. Additionally, the light sources 10 are arranged to form a sphere 14 which sphere corresponds to the outer surface of the shell.

A plurality of the light sources 10 is arranged along a straight line on a plurality of flexible PCBs 16, where the PCBs extend at least along a part of the ring 12. See e.g., detail B of Fig. 3. The flexible PCBs 16 are arranged along the inner surface 8 of the shell 2. The shell 2 comprises a plurality of openings 18 through which the light sources 10 arranged on the PCBs partly extend.

Each of the PCBs 16 extends from an upper section 20 of the shell to a lower section 22 of the shell 2, where the upper and lower sections 20, 22 cover opposite extremities of the shell 2.

A first distance D1 between two neighbouring PCBs 16 at the upper and the lower section is smaller than a second distance D2 between two neighbouring PCBs at a shell centre C line between the upper and the lover sections 20, 22.

The display device 1 comprises a replaceable cover 24. As an example, the cover may comprise a plurality of cover parts (not shown) which may be releasable attached to each other. The cover 24 may be made of a material which scatters light, whereby the cover 24 may act as a diffuser. The cover may additionally or alternatively act as a lens or a pixel separator to isolate a pixel e.g., as a square on the surface.

The display device 1 comprises a wire 26 configured to carry the shell 2, e.g., to hang the shell from a ceiling or from a carrier structure. The wire 26 extends from the inner space 4 to the surrounding space 28 via an opening 30 in the shell 2. A first end 32 of the wire 26 is be attached to a fixation element 34 in the inner space. An opposite second end (not shown) may be attached to a second fixation element (not shown) e.g., at the ceiling.

Additionally, the display device 1 comprises a winch 36 positioned in the inner space. The fixation element 34 is fixed to the winch 36 which is configured for up and down movement of the shell 2.

The display device 1 comprises a fan 38 positioned in the inner space 4 of the shell 2. The fan 38 is configured to cool the inner space 4 by providing a flow of air from outside the shell to the inner space 4 and from the inner space 4 to the outside 38. The flow is provided via an opening 40 in the bottom part of the shell 2 and a corresponding opening 30 at the top part of the shell.

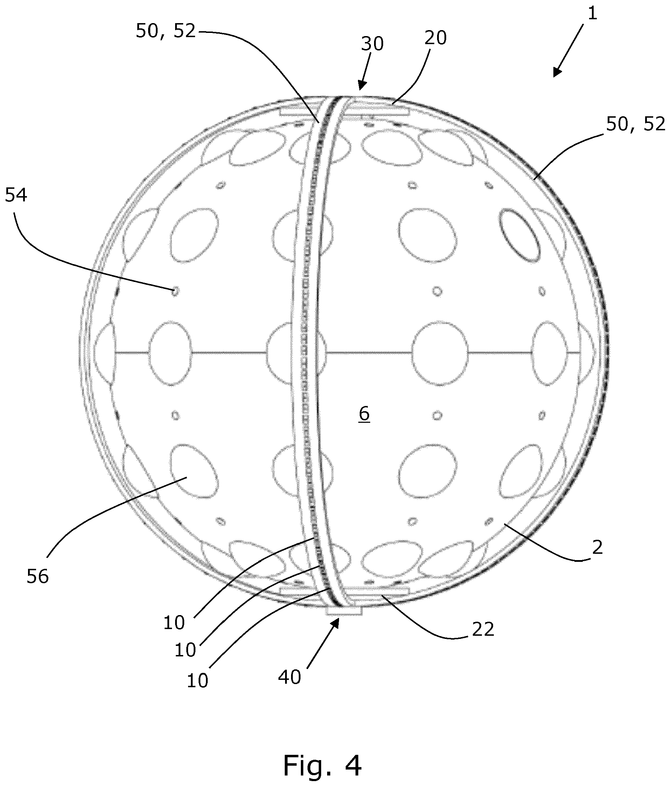

Fig. 4 illustrates an alternative embodiment of display device 1. The display device 1 comprises a shell 2 forming an inner space (not shown). The shell 2 has an outer surface 6 and an opposite inner surface (not shown). The display device 1 comprises a plurality of light sources 10, and is configured for displaying a three-dimensional picture, such as moving images, such as video, by coordinated activation of a plurality of the light sources 10. In the illustrated embodiment, most of the light sources 10 are arranged to form two rings 12 being substantially circular along the outer surface 6 of the shell 2.

A plurality of the light sources 10 is arranged along a straight line on a plurality of flexible PCBs 16, where the PCBs extend at least along a part of the ring 12. The display device 1 comprises two carrier elements 50 each carrying a plurality of light sources 10, where the carrier elements 50 are arranged along the outer surface 6 of the shell 2. The carrier elements 50 are movably arranged relative to the shell 2 to allow rotation of the carrier elements around the shell. A three-dimensional picture, e.g., moving images, such as video, is displayed by coordinated activation of a plurality of the light sources 10 during rotation of the carrier elements.

The carrier elements each comprise two carrier arms 52 in the form of half-rings, each extending along the outer surface of the shell. To facilitate stability of the display device 1, the two times two arms 52 are symmetrically arranged relative to the shell. To improve the pixel density on the outer surface of the shell 2, the light sources 10 at the carrier arms 52 are staggered relative to each other; i.e., the light sources 10 of a carrier arm 52 is staggered relative to the light sources 10 of a neighbouring carrier arm 52, the light sources 10 being staggered in a direction from the upper section 20 to the lower section 22.

The display device 1 comprises a motor (not shown) configured for rotation of the carrier elements 50 relative to the shell. The display device 1 further comprises a cover 24 arranged circumferential around the shell and the carrier elements 50 to prevent a person touching the moving (spinning) carrier elements.

In the illustrated embodiment, the display device 1 further comprises a plurality of light guiding rods 54, where a plurality of light sources is arranged in the inner space to provide a lighting effect in addition to the pictures/moving images/video provided by the light sources 10 at the spinning/rotating carrier elements 50. The display device 1 further comprises a plurality of lenses 56 arranged at openings (not shown) at the shell 2. Light beams provided via the lenses 56 may also add to the pictures/moving images/video provided by the light sources 10 at the spinning/rotating carrier elements 50.

The display device 1 illustrated in Fig. 4 may comprise a winch and a fan as described in connection to the embodiment illustrated in Figs. 1-3.

*The following numbered items are provided:*
Item 1. A display device comprising a shell forming an inner space and having an outer surface and an opposite inner surface, and a plurality of light sources, the device being configured for displaying a three-dimensional picture by coordinated activation of a plurality of the light sources, and wherein at least some of the light sources are arranged to form at least one ring.
Item 2. The display device according to item 1, wherein the at least one ring is circular.
Item 3. The display device according to item 1 or 2, wherein at least some of the light sources are arranged to form a sphere.
Item 4. The display device according to any of the preceding items, wherein a plurality of the light sources is arranged along a straight line on at least one flexible PCB, and wherein the at least one PCB extends at least along a part of the ring.
Item 5. The display device according to item 4, wherein the at least one flexible PCB is arranged along the inner surface, wherein the shell comprises a plurality of openings, and wherein the light sources arranged on the PCB extend at least partly through the openings.
Item 6. The display device according to item 4 or 5, wherein a plurality of PCBs extends from an upper section of the shell to a lower section of the shell, the upper section and the lower section covering opposite extremities of the shell, and wherein a first distance between two neighbouring PCBs at the upper and the lower section is smaller than a second distance between two neighbouring PCBs at a shell centre line between the upper and the lover section.
Item 7. The display device according to item 6, wherein the shell defines a centre axis extending through a geometrical centre of the shell from a top part of the upper section and a bottom part of the lower section, and wherein each PCBs is arranged such that each light source of that PCB is arranged in a plane extending through the shell centre axis.
Item 8. The display device according to item 6 or 7, wherein the light sources are arranged equidistant along the PCB(s).
Item 9. The display device according to any of items 6-8, wherein a plurality of the PCBs is arranged symmetrically relative to each other.
Item 10. The display device according to any of items 6-9, further comprising a supplementary source of light extending along the outer surface of the shell transverse to the shell centre axis.
Item 11. The display device according to item 10, wherein the supplementary source of light comprises a light rod.
Item 12. The display device according to item 10, wherein the supplementary source of light comprises a plurality of LEDs.
Item 13. The display device according to any of items 10-12, wherein the supplementary source of light extends circumferentially around the shell along a centre line.
Item 14. The display device according to any of the preceding items, further comprising a carrier element carrying a plurality of light sources, wherein the carrier element is arranged along the outer surface of the shell and being movably arranged relative to the shell to allow rotation of the carrier element around the shell.
Item 15. The display device according to item 14, wherein the carrier element comprises two carrier arms, and wherein the light sources are arranged along a straight line extending from an upper section of the shell to a lower section of the shell, wherein the light sources of a first carrier arm being staggered relative to the light sources of a second carrier arm, the light sources being staggered in a direction from the upper section to the lower section.
Item 16. The display device according to item 14 or 15, further comprising a motor configured to rotate the carrier element relative to the shell.
Item 17. The display device according to any of the preceding item, further comprising a cover arranged circumferential around the shell.
Item 18. The display device according to any of the preceding items, further comprising a plurality of reflective elements for reflection of light emitted from at least some of the light sources.
Item 19. The display device according to any of the preceding items, further comprising a wire configured to carry the shell, wherein the wire extends from the inner space to a surrounding space via an opening at in the shell, a first end of the wire being attached to a fixation element in the inner space.
Item 20. The display device according to item 19, further comprising a winch positioned in the inner space, the fixation element being fixed to the winch, the winch being configured for up and down movement of the shell.
Item 21. The display device according to any of the preceding items, further comprising a fan positioned in the inner space, the fan being configured to cool the inner space.
Item 22. The display device according to item 20, wherein the fan is configured to provide a flow of air from outside the shell to the inner space and from the inner space to the outside.
Item 23. The display device according to any of the preceding items, wherein at least some of the light sources are covered by a diffuser or a lens.
Item 24. The display device according to item 23, further comprising a cover arranged circumferentially around the shell, wherein the cover comprises the diffusers and/or the lenses.
Item 25. The display device according to item 24, wherein the cover comprises a plurality of cover parts being releasable attached to each other.
Item 26. The display device according to any of the preceding items, wherein the light sources are selected from a group consisting of: RGB LEDs, RGBW LEDs, laser, and combinations hereof.
Item 27. The display device according to any of the preceding items, wherein the shell comprises a plurality of shell parts, where each shell part is releasably attached to an adjacent shell part.

## Claims

1. A display device comprising a shell forming an inner space and having an outer surface and an opposite inner surface, and a plurality of light sources, the device being configured for displaying a three-dimensional picture by coordinated activation of a plurality of the light sources, wherein at least some of the light sources are arranged to form at least one ring, and wherein a plurality of the light sources is arranged along a straight line on at least one flexible PCB, and wherein the at least one PCB extends at least along a part of the ring.

2. The display device according to claim 1, wherein the at least one flexible PCB is arranged along the inner surface, wherein the shell comprises a plurality of openings, and wherein the light sources arranged on the PCB extend at least partly through the openings.

3. The display device according to claim 2, wherein a plurality of PCBs extends from an upper section of the shell to a lower section of the shell, the upper section and the lower section covering opposite extremities of the shell, and wherein a first distance between two neighbouring PCBs at the upper and the lower section is smaller than a second distance between two neighbouring PCBs at a shell centre line between the upper and the lower section.

4. The display device according to claim 2 or 3, wherein the shell defines a centre axis extending through a geometrical centre of the shell from a top part of the upper section and a bottom part of the lower section, and wherein each PCBs is arranged such that each light source of that PCB is arranged in a plane extending through the shell centre axis.

5. The display device according to any of the preceding claims, further comprising a supplementary source of light extending along the outer surface of the shell transverse to a shell centre axis.

6. The display device according to claim 5, wherein the supplementary source of light comprises a light rod.

7. The display device according to claim 5, wherein the supplementary source of light comprises a plurality of LEDs.

8. The display device according to any of the preceding claims, further comprising a carrier element carrying a plurality of light sources, wherein the carrier element is arranged along the outer surface of the shell and being movably arranged relative to the shell to allow rotation of the carrier element around the shell.

9. The display device according to claim 8, wherein the carrier element comprises two carrier arms, and wherein the light sources are arranged along a straight line extending from an upper section of the shell to a lower section of the shell, wherein the light sources of a first carrier arm being staggered relative to the light sources of a second carrier arm, the light sources being staggered in a direction from the upper section to the lower section.

10. The display device according to claim 8 or 9, further comprising a motor configured to rotate the carrier element relative to the shell.

11. The display device according to any of the preceding claim, further comprising a cover arranged circumferential around the shell.

12. The display device according to any of the preceding claims, further comprising a wire configured to carry the shell, wherein the wire extends from the inner space to a surrounding space via an opening at in the shell, a first end of the wire being attached to a fixation element in the inner space.

13. The display device according to claim 12, further comprising a winch positioned in the inner space, the fixation element being fixed to the winch, the winch being configured for up and down movement of the shell.

14. The display device according to any of the preceding claims, further comprising a fan positioned in the inner space, the fan being configured to cool the inner space, and wherein the fan is configured to provide a flow of air from outside the shell to the inner space and from the inner space to the outside.

15. The display device according to any of the preceding items, wherein at least some of the light sources are covered by a diffuser or a lens.
